# EUROPÄISCHE PATENTSCHRIFT

(11) **EP 0 880 656 B1**
(45) Veröffentlichungstag und Bekanntmachung des Hinweises auf die Patenterteilung: **07.01.2004**
(21) Anmeldenummer: 97947689.2
(22) Anmeldetag: 18.10.1997
(51) Int. Cl.: F16J 3/02

(54) **WASSERDICHTES KUNSTSTOFFBAUTEIL, INSBESONDRE KUNSTSTOFFGEHÄUSE**
TIGHT PLASTIC PART, ESPECIALLY PLASTIC CASING
ELEMENT PLASTIQUE ETANCHE, ET PLUS PARTICULIEREMENT BOITIER PLASTIQUE

(30) Priorität: 19.12.1996 DE 19652926
(43) Veröffentlichungstag der Anmeldung: 02.12.1998
(73) Patentinhaber: ROBERT BOSCH GMBH, 70442 Stuttgart (DE)
(72) Erfinder: URSEL, Eckhard, D-77815 Bühl (DE); FREUND, Stefan, D-76571 Gaggenau (DE)
(86) Internationale Anmeldenummer: PCT/DE1997/002408
(87) Internationale Veröffentlichungsnummer: WO 1998/027370

(56) Entgegenhaltungen:
- EP-A- 0 417 344
- EP-A- 0 522 183
- WO-A-88/09422
- US-A- 5 348 570

## Beschreibung

Die Erfindung betrifft ein wasserdichtes Kunststoffbauteil, insbesondere Kunststoffgehäuse, der im Oberbegriff des Anspruchs 1 definierten Gattung.

Bei einem bekannten als Antriebsgehäuse für eine elektrische Antriebsvorrichtung zum Verstellen eines Abdeckelements für eine Öffnung in der Karosserie eines Kraftfahrzeugs, wie Fensterscheibe, Schiebedach od.dgl., ausgebildeten Kunststoffbauteils (WO 88/09422), ist die in der topfartigen Gehäuseausnehmung einliegenden Membran durch ein tellerförmiges Federelement gehalten, das sich in der Zylinderwand der Gehäuseausnehmung nach Art einer sog. Speednut-Sicherung verkrallt. Zwischen dem Membranrand und dem Federelement ist eine als O-Ring ausgebildeten Dichtung eingelegt, die vom Federelement zusammen mit dem Membranrand gegen einen dem Grund der Gehäuseausnehmung vorgelagerte, ringförmige Abstützschulter festgespannt wird.

### Vorteile der Erfindung

Das erfindungsgemäße wasserdichte Kunststoffbauteil mit den kennzeichnenden Merkmalen des Anspruchs 1 hat den Vorteil, daß die Membran mit Dichtungsring einfach in die Hinterschneidungen der Segmentlappen eingedrückt wird und dort zuverlässig unter Abdichtung der Membran gegenüber der Zylinderwand der Gehäuseausnehmung gehalten wird. Dadurch entfällt das Federelement, was zur Kostensenkung beiträgt.

Durch die in den weiteren Ansprüchen aufgeführten Maßnahmen sind vorteilhafte Weiterbildungen und Verbesserungen des im Anspruch 1 angegebenen wasserdichten Kunststoffbauteils möglich.

Gemäß einer vorteilhaften Ausführungsform der Erfindung sind die Segmentlappen um gleiche Drehwinkel zueinander versetzt über den Innenumfang der zylindrischen Innenwand der Gehäuseausnehmung angeordnet und werden bei der Spritzgußherstellung des Bauteils gleich mit angeformt. Dabei werden die Hinterschneidungen der Segmentlappen, das ist der freie Raum zwischen den Segmentlappen und dem Boden oder Grund der topfförmigen Gehäuseausnehmung, durch drehende Entformung eines inneren Stempelteils eines zweiteiligen Innenformstempels gebildet, dessen den inneren Stempelteil konzentrisch umschließender äußerer Stempelteil zuvor von diesem axial abzuziehen ist. Durch diese Maßnahmen läßt sich das Kunststoffbauteil in einem einzigen Spritzvorgang komplett fertigen und bedarf keiner zusätzlichen spanenden Bearbeitungsvorgänge.

### Zeichnung

Die Erfindung ist anhand eines in der Zeichnung dargestellten Ausführungsbeispiels in der nachfolgenden Beschreibung näher erläutert. Es zeigen:
- Fig. 1: ausschnittweise einen Längsschnitts eines als Gehäuse ausgebildeten Kunststoffbauteils,
- Fig. 2: eine Ansicht des Gehäuseausschnitts in Richtung Pfeil II in Fig. 1,
- Fig. 3: eine vergrößerte Darstellung des Ausschnitts III in Fig. 1,
- Fig. 4: ausschnittweise einen Längsschnitt eines zweiteiligen Innenformstempels zum Spritzgießen des Kunststoffgehäuses,
- Fig. 5: eine Ansicht des Innenformstempels in Richtung V in Fig. 4.

### Beschreibung des Ausführungsbeispiels

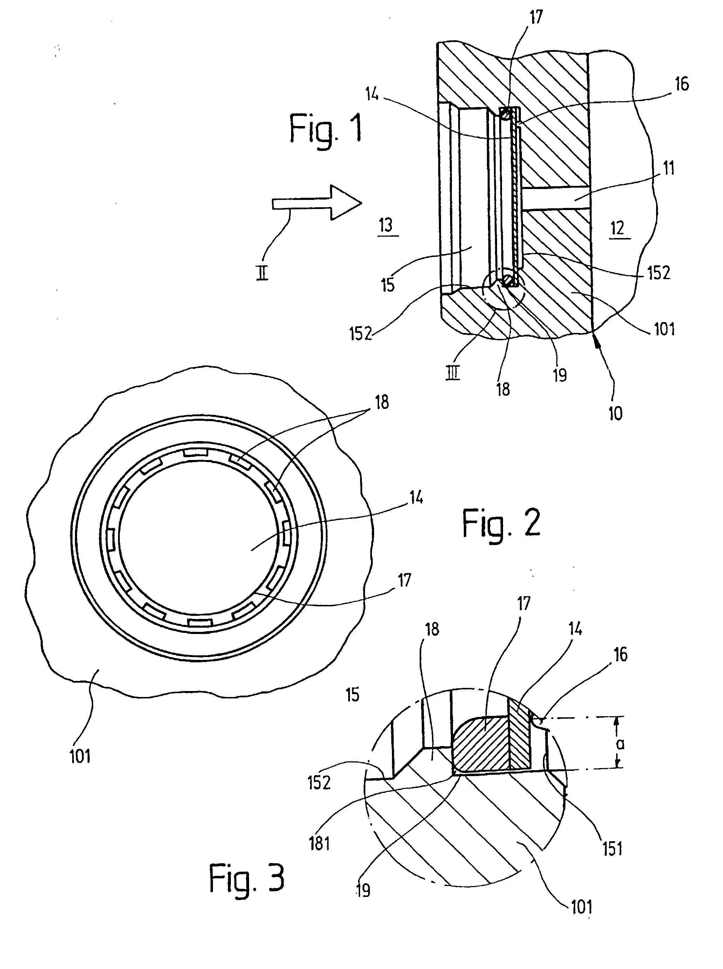

Das in Fig. 1 ausschnittweise im Längsschnitt dargestellte Kunststoffgehäuse 10 als ein Beispiel für ein allgemeines wasserdichtes Kunststoffbauteil weist eine Lüftungsöffnung 11 zum Luftaustausch zwischen dem Gehäuseinneren 12 und der Gehäuseumgebung 13 auf, die zum Verhindern von Wassereintritt in das Gehäuseinnere 12 mit einer gasdurchlässigen Membran 14 überdeckt ist. Koaxial zur Lüftungsöffnung 11 ist in die Gehäusewand 110 von außen her eine stufig abgesetzte, topfförmige Ausnehmung 15 eingebracht, in deren Grund 151 die Lüftungsöffnung 11 mündet. Am Grund 151 der Ausnehmung 15 ist ein zur Mündung der Mündungsöffnung 11 konzentrischer Ringsteg 16 ausgebildet, der einen Radialabstand a vom Außenumfang des Grundes 151 einhält (Fig. 3). Auf diesen vom Grund 151 der Ausnehmung 15 axial vorstehenden Ringsteg 16 ist die Membran 14 aufgelegt und mittels eines randseitig auf die Membran 14 aufgesetzten Dichtungsrings 17 gegenüber der Zylinderwand 152 der Ausnehmung 15 wasserdicht abgedichtet. In einer alternativen Ausführungsform kann der Dichtungsring 17 auch einstückig an die Membran 14 angeformt sein. Die Festlegung von Membran 14 mit Dichtungsring 17 erfolgt durch Segmentlappen 18, die in einem Axialabstand vom Grund 151 der Ausnehmung 15 unter Bildung von Hinterschneidungen 19 radial von der Zylinderwand 152 der Ausnehmung 15 vorstehen und den Dichtungsring 17 übergreifen. Der axiale Abstand der Segmentlappen 18 von dem Grund 151 der Ausnehmung 15 ist so gewählt, daß er etwa der Summe der axialen Dicken von Membran 14 und Dichtungsring 17 entspricht, so daß diese zwischen dem Ringsteg 16 und den Segmentlappen 18 eingedrückt werden können und dort zuverlässig festliegen. Wie Fig. 2 zeigt, sind die Segmentlappen 18 um gleiche Umfangswinkel gegeneinander versetzt über den Umfang der Zylinderwand 152 der Ausnehmung 15 angeordnet.

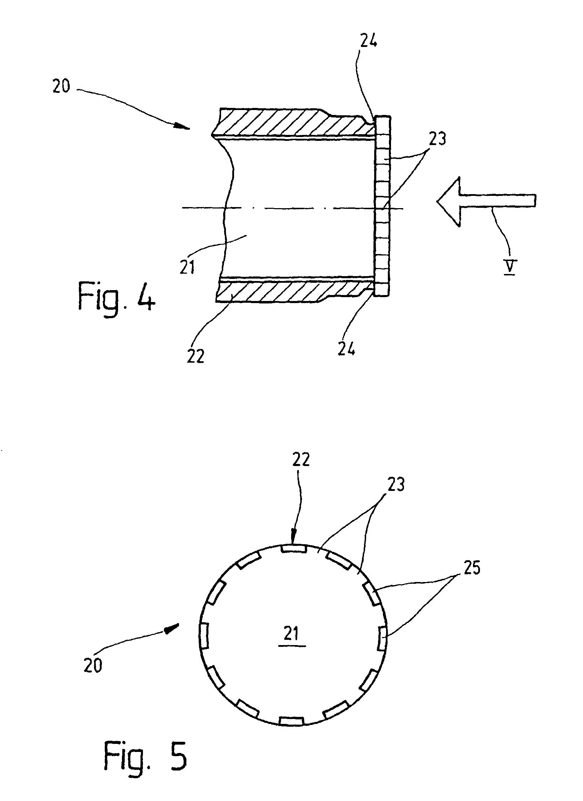

Die Segmentlappen 18 werden bei der Herstellung des als Sprizgußteil ausgebildeten Kunststoffgehäuses 10 bei gleichzeitiger Ausformung der Lüftungsöffnung 11 gleich mit ausgebildet. Beim Kunststoffspritzen des Gehäuses 10 ist zur Ausbildung der Lüftungsöffnung 11 ein zweiteiliger Innenformstempel 20, wie er in Fig. 4 ausschnittweise dargestellt ist, erforderlich. Dieser zweiteilige Innenformstempel 20 weist einen inneren Stempelteil 21 und einen diesen koaxial umschließenden äußeren Stempelteil 22 auf. Der innere Stempelteil 21 trägt an seiner einen Stirnseite radial wegstrebende Ringsegmente 23, deren Abmessungen in der Ebene quer zur Stempelachse den Abmessungen der radialen Segmentlappen 18 in der Ausnehmung 15 entsprechen sowie um den gleichen Drehwinkel wie die Segmentlappen 18 voneinander über den Umfang des Stempelteils 21 verteilt sind und deren axiale Höhe dem Abstand zwischen der Hinterschneidungsfläche 181 der Segmentklappen 18 und dem Grund 151 der Ausnehmung 15, also der axialen Tiefe der Hinterschneidung 19, entspricht. Der äußere Stempelteil 22 ist mit seiner äußeren Umfangsstruktur der stufig abgesetzten Zylinderwand 152 der topfförmigen Ausnehmung 15 nachgebildet und weist zur Ausbildung der Segmentlappen 18 beim Spritzvorgang mit diesen und mit den mit diesen axial fluchtenden Ringsegmenten 23 am inneren Stempelteil 21 abmessungsgleiche, stirnseitige Aussparungen 24 auf. Zwischen diesen von der Stirnseite des äußeren Stempelteils 22 her eingebrachten Aussparungen 24 verbleiben Klauen 25, die formschlüssig zwischen die Ringsegmente 23 am inneren Stempelteil 21 hindurchragen und mit den Ringsegmenten 23 axial bündig enden.

Der beschriebene zweiteilige Inneformstempel 20 wird zur Ausformung der Ausnehmung 15 zusammen mit einem weiteren koaxialen Innenformstempel zur Ausformung der Lüftungsöffnung 11 in die Spritzgußform eingelegt. Nach Einfüllen des Kunststoffmaterials, das in die zwischen den Ringsegmenten 23 am inneren Stempelteil 21 und den damit axial fuchtenden Aussperrungen 24 im äußeren Stempelteil 22 verbleibenden Hohlräume einfließt und dadurch die Segmentlappen 18 bildet, und dessen Aushärten erfolgt die Entformung, wobei zunächst der äußere Stempelteil 22 axial vom inneren Stempelteil 21 abgezogen wird und dann die Entformung des inneren Stempelteils 21 zunächst durch Drehung um einen Drehwinkel, der dem Abstandswinkel der Ringsegmente 23 voneinander entspricht, und anschließendes axiales Abziehen des inneren Stempelteils 21 durchgeführt wird.

## Patentansprüche

1. Wasserdichtes Kunststoffbauteil, insbesondere Kunststoffgehäuse, mit einer Lüftungsöffnung (11) zum Luftaustausch zwischen dem Bauteilinnem (12) und der Bauteitumgebung (13) und mit einer die Lüftungsöffnung (11) überdeckenden, gasdurchlässigen Membran (14) zum Verhindern von Wassereintritt durch die Lüftungsöffnung (11) hindurch ins Bauteilinnere (12), die in einer der Mündung der Lüftungsöffnung (11) vorgesetzten topfförmigen, eine Zylinderwand (152) aufweisenden Ausnehmung (15) einliegt und am Grund (151) derAusnehmung (15) zusammen mit einem Dichtungsring (17) randseitig eingespannt ist, **dadurch gekennzeichnet, daß** Dichtungsring (17) und Membranrand von Segmentlappen (18) übergriffen sind, die unter Bildung von Hinterschneidungen (19) mit Hinterschneidungsflächen (181) radial von der Zylinderwand (152) einstückig mit dieser vorstehen, und daß der Axialabstand der Hinterschneidungsflächen (181) vom Grund (151) derAusnehmung (15) etwa der Summe der axialen Dicken von Membranrand und Dichtungsring (17) entspricht.

2. Bauteil nach Anspruch 1, **dadurch gekennzeichnet, daß** der Dichtungsring (17) einstückig an dem Membranrand angeformt ist.

3. Bauteil nach Anspruch 1 oder 2, **dadurch gekennzeichnet, daß** die Segmentlappen (18) um gleiche Drehwinkel zueinander versetzt über den Innenumfang der Zylinderwand (152) der Ausnehmung (15) angeordnet sind und bei der Spritzgußherstellung des Bauteils gleich mit angeformt werden.

4. Bauteil nach Anspruch 3, **dadurch gekennzeichnet, daß** die Hinterschneidungen (19) der Segmentlappen (18) durch drehende Entformung eines inneren Stempelteils (21) eines zweiteiligen Innenformstempels (20) gebildet sind, dessen den inneren Stempelteil (21) konzentrisch umschließender äußerer Stempelteil (22) zuvor von diesem axial abzuziehen ist.

## Claims

1. Watertight plastic component, in particular plastic housing, with a ventilation opening (11) for exchanging air between the component interior (12) and the component surroundings (13), and with a gas-permeable diaphragm (14), covering the ventilation opening (11), for preventing water ingress through the ventilation opening (11) into the component interior (12), the said diaphragm (14) fitting into a recess (15), which is arranged in front of the mouth of the ventilation opening (11), is cup-shaped and has a cylinder wall (152), and being clamped in at its edge at the bottom (151) of the recess (15) together with a sealing ring (17), **characterized in that** segmental tabs (18) engage over the sealing ring (17) and diaphragm edge and project radially from the cylinder wall (152) integrally with the latter while forming undercuts (19) having undercut surfaces (181), and **in that** the axial spacing between the undercut surfaces (181) and the bottom (151) of the recess (15) corresponds approximately to the sum of the axial thicknesses of the diaphragm edge and sealing ring (17).

2. Component according to Claim 1, **characterized in that** the sealing ring (17) is integrally moulded on the diaphragm edge.

3. Component according to Claim 1 or 2, **characterized in that** the segmental tabs (18) are arranged over the internal circumference of the cylinder wall (152) of the recess (15) at equal rotary angles from each other and are moulded on at the same time as the component is manufactured by injection moulding.

4. Component according to Claim 3, **characterized in that** the undercuts (19) of the segmental tabs (18) are formed by rotationally removing an inner die part (21) of a two-part inner shape ram (20), whose outer die part (22), surrounding the inner die part (21) concentrically, must be pulled off axially from the said inner die part (21) prior to this.

## Revendications

1. Composant plastique étanche, en particulier un boîtier plastique, comportant un orifice d'aération (11) servant à l'échange d'air entre l'intérieur (12) et l'extérieur (13) du composant, et une membrane (14) perméable aux gaz recouvrant l'orifice d'aération (11) et servant à empêcher toute pénétration d'eau par l'orifice d'aération (11) dans l'intérieur du composant (12), et qui est appliquée à l'intérieur d'un évidement (15) en forme de récipient prévu au niveau de l'une des extrémités de l'orifice d'aération (11) avec une paroi cylindrique (152), et qui est serrée par ses bords au fond (151) de l'évidement (15) conjointement avec une bague d'étanchéité (17),
**caractérisé en ce que**
la bague d'étanchéité (17) et le bord de la membrane sont enserrés par des ergots segmentaires (18) qui forment des contre-dépouilles (19) avec des surfaces de contre-dépouille (181) qui font saillie radialement à partir de la paroi cylindrique (152) d'une seule pièce avec cette dernière, et la distance axiale existant entre les surfaces de contre-dépouille (181) et le fond (151) de l'évidement (15) correspond à peu près à la somme des épaisseurs axiales du bord de la membrane et de la bague d'étanchéité (17).

2. Composant selon la revendication 1,
**caractérisé en ce que**
la bague d'étanchéité (17) est formée d'une seule pièce sur le bord de la membrane.

3. Composant selon la revendication 1 ou 2,
**caractérisé en ce que**
les ergots segmentaires (18) sont disposés sur la circonférence intérieure de la paroi cylindrique (152) de l'évidement (15), espacés l'un de l'autre selon des angles identiques, et sont formés de manière identique lors de la fabrication de l'élément moulé par injection.

4. Composant selon la revendication 3,
**caractérisé en ce que**
les contre-dépouilles (19) des ergots segmentaires (18) sont formées par démoulage rotatif d'une partie intérieure de poinçon (21) d'un poinçon de moule intérieur (20) formé de deux parties, dont la partie extérieure de poinçon (22) entourant concentriquement la partie intérieure de poinçon (21) est au préalable retirée axialement de cette dernière.
